**Europäisches Patentamt**

**European Patent Office**

**Office européen des brevets**

(19)

(11) Veröffentlichungsnummer : **0 018 499**
**B1**

(12) **EUROPÄISCHE PATENTSCHRIFT**

(45) Veröffentlichungstag der Patentschrift :
22.09.82

(21) Anmeldenummer : 80101624.7

(22) Anmeldetag : 27.03.80

(51) Int. Cl.³ : **C 23 C   3/00,** B 23 K 26/00,
**H 05 K   3/18**

(54) **Verfahren zum selektiven Plattieren der Oberfläche eines Werkstücks.**

(30) Priorität : 08.05.79 US 37073

(43) Veröffentlichungstag der Anmeldung :
12.11.80 (Patentblatt 80/23)

(45) Bekanntmachung des Hinweises auf die Patenterteilung : 22.09.82 Patentblatt 82/38

(84) Benannte Vertragsstaaten :
DE FR GB

(56) Entgegenhaltungen :
US A 3 296 359
US A 3 839 083

(73) Patentinhaber : **International Business Machines Corporation**
**Armonk, N.Y. 10504 (US)**

(72) Erfinder : **Blum, Samuel Emil**
**18-1 Granada Cresecent**
**White Plains, N.Y. 10603 (US)**
Erfinder : **Kovac, Zlata**
**Lee Road**
**Somers, N.Y. 10589 (US)**
Erfinder : **von Gutfeld, Robert Jacob**
**600 West 115th St.**
**N.Y. 10025 (US)**

(74) Vertreter : **Schröder, Otto H., Dr.-Ing.**
**c/o International Business Machines Corporation**
**Zurich Patent Operations Säumerstrasse 4**
**CH-8803 Rüschlikon/ZH (CH)**

EP 0 018 499 B1

Imprimerie Jouve, 18, rue St-Denis, 75001 Paris. France

# 0 018 499

Verfahren zum selektiven Plattieren der Oberfläche eines Werkstücks.

Die Erfindung betrifft ein Verfahren zum selektiven Plattieren der Oberfläche eines Werkstücks, insbesondere zum Herstellen von aufplattierten Mustern ohne Verwendung einer Maske.

Es gibt Verfahren zum Herstellen von Mustern hoher Auflösung durch Verspiegeln oder elektrodenloses Aufplattieren. Um saubere Kanten der Muster zu erzielen, arbeitet man mit Maskierung während der Herstellung. Es wird eine Maske aus Photolack auf die Oberfläche aufgebracht, selektiv belichtet, und entwickelt. In den durch die Maske definierten freien Bereichen wird die Plattierung hergestellt, und anschliessend muss die Maske entfernt werden. Das Verfahren umfasst daher eine Anzahl von Schritten, die sowohl zeitraubend sind als auch zur Erhöhung der Kosten beitragen. Auch wird bei diesen Verfahren die Ausfällungsrate nicht gesteigert, weshalb sie verhältnismässig langsam sind.

Die US Patentschrift 3 530 053 betrifft ein Verfahren zum Niederschlagen eines Films aus Cadmiumsulfid aus einer wässerigen Lösung. Zur Erhöhung der Ausfällungsrate wird die Plattierlösung der intensiven Strahlung einer Lichtquelle ausgesetzt. Das Verfahren ist jedoch für das selektive Plattieren einzelner Bereiche einer Oberfläche nicht geeignet. Die aktivierte Plattierlösung vermischt sich mit Anteilen der nicht aktivierten Lösung. Eine scharfe Begrenzung von plattierten Mustern lässt sich daher nicht erreichen.

Die US Patentschrift 3 993 802 betrifft ein elektrodenloses Plattierverfahren. Die zu plattierende Oberfläche wird mit einer sensibilisierbaren Lösung behandelt. Die beschichtete Oberfläche wird Licht ausgesetzt, um damit eine katalytische Schicht zu bilden, welche die bevorzugte Ablagerung von Metall aus der Lösung fördert. Dieses bekannte Verfahren besteht aus mehreren Schritten und erfordert insbesondere die Anwendung einer besonderen katalytischen Schicht.

Es ist ein Ziel der Erfindung, ein Plattierverfahren anzugeben, das weder elektrische Einrichtungen noch die Anwendung einer Maske erfordert. Ein weiteres Ziel der Erfindung ist, diese Verfahren zur Aenderung oder Reparatur von integrierten Schaltungen auf dem Chip selbst verwenden zu können. Ferner soll durch dieses Verfahren die Ausfällungsrate selektiv verändert werden, um lokale Abstimmungen oder Ausbesserungen der Schichtdicke vornehmen zu können und so eine abriebfeste Oberfläche zu bilden.

Das Verfahren zum selektiven Plattieren der Oberfläche eines Werkstücks ist dadurch gekennzeichnet, dass man das Werkstück mit einer Plattierlösung in Kontakt bringt, und dass man während des Plattierens die zu plattierenden Bereiche selektiv einer scharf gebündelten elektromagnetischen Strahlung aussetzt, welche die ausgewählten Bereiche lokal aufheizt und dort die Ausfällungsrate steigert.

Die Erfindung wird anhand von Ausführungsbeispielen mit Hilfe der Zeichnungen näher erläutert.

Figur 1 ist eine schematische Darstellung einer Anordnung zur Ausführung des Verfahrens.

Figur 2 zeigt schematisch eine Ausführungsform des Werkstücks.

Ein Gefäss 10 enthält ein Bad mit einer Plattierlösung 12. Das Werkstück 14 ist in diese Plattierlösung 12 eingetaucht, so dass seine Oberfläche 16, die plattiert werden soll, mit der Lösung in Kontakt steht. Die Lösung enthält Metallionen. Gebräuchliche Metalle sind beispielsweise Kupfer, Nickel oder Gold. Diese Metallionen aus der Plattierlösung 12 werden direkt auf der Oberfläche 16 ausgefällt, falls diese aus dem gleichen Material besteht.

Die Anodisierung des Werkstückes kann man durch Zusätze zur Plattierlösung wie beispielsweise Palladiumchlorid verbessern.

Das Werkstück 14 ist in horizontaler Lage dargestellt, so dass seine zu plattierende Oberfläche 16 nach oben zeigt. So kann sie am besten von der Strahlungsenergie erreicht werden. Selbstverständlich kann man das Werkstück auch anders orientieren, wenn man die Apparatur dementsprechend einrichtet.

Wenn das Werkstück 14 in der Plattierlösung 12 eingetaucht ist, erfolgt eine gewisse Plattierung auf allen benetzten Flächen einschliesslich der Oberfläche 16. Eine Strahlungsquelle 18 ist vorgesehen, deren Strahlung durch ein Linsensystem 20 in einen Strahl 22 konzentriert wird, der die Plattierlösung 12 durchläuft und auf die Oberfläche 16 einfällt. Die Wellenlänge der Strahlung sollte so bemessen werden, dass die Strahlung durch die Plattierlösung nicht stark absorbiert wird, jedoch möglichst stark durch das Werkstück 14. Es kann Strahlung aus dem sichtbaren Bereich verwendet werden oder aus dem infraroten Teil des Spektrums. Die beste Auflösung von zu plattierenden Mustern erhält man dann, wenn man ein Werkstück 14 verwendet, das eine möglichst geringe Wärmeleitfähigkeit aufweist, damit sich die Wärme von der lokal aufgeheizten Stelle nicht unnötig auf benachbarte Gebiete ausbreitet.

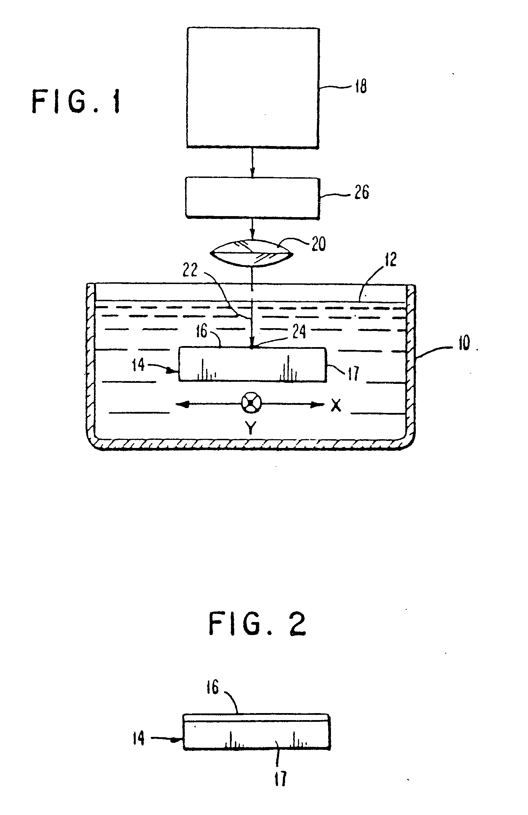

Das Verfahren der durch konzentrierte Strahlung geförderten selektiven elektrodenlosen Plattierung ist besonders für ein Werkstück 14 geeignet, das zusammengesetzter Struktur ist, wobei die zu plattierende Oberfläche 16 eine dünne Schicht aus einem Material ist, welches stark absorbiert, wie beispielsweise ein Metall, und wobei das Substrat 17 aus einem Material mit geringer Wärmeleitfähigkeit besteht, wie bespielsweise aus Glas. In der Fig. 2 ist eine solche zusammengesetzte Struktur des Werkstückes schematisch dargestellt. Diese Struktur verbessert auch die Lokalisierung des aufgeheizten Gebietes und steigert in diesen Gebieten die Rate der bevorzugten Ausfällung. Der Strahl 22 belichtet das Gebiet 24 und bildet dort einen Brennfleck, der dieses Gebiet der Oberfläche 16 lokal aufheizt, wo die selektive Plattierung stattfindet. Durch relative Bewegung von Brennfleck und Werkstück können

2

verschiedene Gebiete nacheinander erreicht werden. In der Zeichnung ist ein ortsfester Strahl dargestellt. Das Werkstück 14 kann in seiner Ebene in zwei Koordinatenrichtungen bewegt werden, was durch die Pfeilrichtungen X und Y angedeutet ist.

Wenn elektromagnetische Strahlung aus dem sichtbaren Bereich verwendet wird, kann ein Kohlelichtbogen verwendet werden. Vorzugsweise verwendet man jedoch einen Laser. Der Laser bildet eine Strahlungsquelle 18 hoher Intensität, wodurch auch die Notwendigkeit für ein Linsensystem 20 entfallen kann, falls nicht eine stärkere Fokussierung des Strahls auf einen möglichst kleinen Brennfleck erwünscht ist. In allen Fällen sollte die Intensität der Strahlung ausreichen, einen Strahl 22 zu erzeugen, dessen Energiedichte am Ort des Brennflecks zwischen $10^2$ und $10^6$ W/cm$^2$ liegt.

Der untere grenzwert sollte noch ausreichen, die zu plattierenden Gebiete so aufzuheizen, dass die Ausfällungsrate gesteigert wird. Der obere Grenzwert ist dadurch gegeben, dass durch die Wärmebehandlung keine bleibenden Strukturveränderungen des Werkstückes erzeugt werden. Daher wird die Energiedichte im allgemeinen auf $10^6$ W/cm$^2$ begrenzt.

Wenn der Strahl 22 grössere Strecken in der Plattierlösung 12 durchläuft, muss man darauf achten, dass die Wellenlänge der Strahlung so gewählt ist, dass die Strahlung nicht stark durch die Lösung 12 absorbiert wird. Es sei erwähnt, dass dies im Gegensatz zur technischen Lehre der obenerwähnten US Patentschrift 3 530 053 steht. Andere Anordnungen sind möglich, wobei der Strahl 22 in der Plattierlösung 12 keine längeren Wege durchlaufen muss. Wenn beispielsweise nur die Oberfläche 16 des Werkstückes 14 durch die Plattierlösung 12 benetzt wird, dann kann der Strahl 22 in das Werkstück 14 von der Rückseite der einfallen. Dann muss aber noch eine gewisse Wärmeleitfähigkeit vorhanden sein, welche den Transport der Wärme zur Oberfläche 16 hin ermöglicht. Bei rückwärtiger Beleuchtung wird die Grösse des Brennflecks in der Grössenordnung der Schichtstärke der Oberfläche 16 liegen. Um gute Auflösung zu erreichen, sollte daher der Brennfleck so scharf wie möglich sein.

Die gleiche Methode mit der Bestrahlung von der Rückseite her kann auch für ein dickeres Werkstück 14 zusammengesetzter Struktur nach Fig. 2 angewendet werden. In diesem Falle ist es wünschenswert, eine Oberfläche 16 zu haben, die stark absorbiert und deshalb vorzugsweise ein Metall ist und ein Substrat 17, das für die angewendete Strahlung transparent ist.

Der von der Strahlungsquelle 18 gelieferte Strahl 22 kann durch einen Modulator 26 moduliert werden, der zwischen der Strahlungsquelle 18 und dem Linsensystem 20 oder zwischen dem Linsensystem 20 und dem Werkstück 14 angeordnet ist. Der Modulator 26 kann ein mechanischer Zerhacker sein, wenn die Modulationsfrequenz niedrig ist, oder ein optischer Modulator, wenn die Modulationsfrequenz höher ist. Optische Modulation erlaubt Frequenzen bis in den Bereich von einigen Gigahertz.

Eine Plattierung erfolgt vorzugsweise in dem Gebiet 24, das durch das einfallende Licht aufgeheizt wird. Für Oberflächen 16 mit endlicher Wärmeleitfähigkeit ist es empfehlenswert, die Strahlung zu pulsen, um so schärfer ausgeprägte Temperaturprofile in der Umgebung des der Strahlung ausgesetzten Gebietes 24 zu erreichen. So wird die Ausfällungsrate gesteigert und die Kantenschärfe verbessert.

Die Modulation der Laserstrahlung bewirkt eine Begrenzung der Ausbreitung der Wärme im Substrat infolge der Wärmeleitung, was sonst zur Verschlechterung der Auflösung führen würde.

Alle bis jetzt beschriebenen Verfahren verwenden einen einzelnen Strahl 22, der auf das Werkstück 14 einfällt. Selbstverständlich könnte man auch mehrere Strahlen verwenden und somit gleichzeitig an mehreren Orten selektiv plattieren.

Beispiel I

Etwa 100 Å starke Nickelschichten sind auf gläserne Substrate der Stärke 0,03 mm aufgedampft. Diese zusammengesetzten Strukturen werden als Werkstück verwendet. Die vernickelten Oberflächen werden mit einer Plattierlösung in Kontakt gebracht, welche die folgende Zusammensetzung hat :

|       |     |            |
| ----- | --- | ---------- |
| 0,1   | Mol | $NiSO_4$   |
| 0,2   | Mol | $NaH_2PO_2$ |
| 1,0   | Mol | $NH_4Cl$   |

$NH_4OH$ wird in genügender Menge zugesetzt, um den pH-Wert zwischen 8 und 9 einzustellen. Dann wird noch 1 g/l Na-Saccharin zugefügt.

Der Strahl eines auf 5 145 Å abgestimmten Argonlasers wird ununterbrochen durch die Lösung geschickt und beleuchtet Gebiete auf der Oberfläche der Nickelschichten. Der Strahl heizt zu plattierende Gebiete lokal auf. Der Durchmesser des Brennflecks beträgt etwa 170 μm. Die Energiedichte beträgt etwa $1 \times 10^3$ W/cm$^2$.

Die Plattierung als eine Funktion der Belichtungszeit ist für verschiedene Proben in der folgenden Tabelle zusammengestellt.

(Siehe die Tabelle, Seite 4)

| Zeit | Dicke | Durchmesser | Ausfällungsrate |
|------|-------|-------------|-----------------|
| (s) | (Å) | (µm) | (Å/s) |
| 5 | 2 500 | 160 | 500 |
| | 2 100 | | 420 |
| | 2 400 | | 480 |
| 10 | 8 000 | 175 | 800 |
| | 7 500 | | 750 |
| | 7 000 | | 700 |
| 15 | 12 000 | 170 | 800 |
| | 10 000 | | 670 |
| | 9 000 | | 600 |
| | 11 000 | | 730 |

## Beispiel II

Die Werkstücke sind in gleicher Weise präpariert und werden in die Plattierlösung eingebracht wie in Beispiel I beschrieben. Der Laserstrahl wird jetzt von der Rückseite her auf das Werkstück gerichtet, durchdringt das gläserne Substrat und fällt auf die Grenzschicht zwischen Glas und Nickel ein. Dadurch werden die Gebiete der Metallschicht lokal erhitzt, wo Plattierung erfolgen soll. Die Ausfällungsraten auf den freien Oberflächen (d.h. den dem Lichteinfall abgewandten Oberflächen), welche in Kontakt mit der Plattierlösung stehen, sind in folgender Tabelle zusammengefasst :

| Zeit | Dicke | Durchmesser | Ausfällungsrate |
|------|-------|-------------|-----------------|
| (s) | (Å) | (µm) | (Å/s) |
| 5 | 1 100 | 150 | 220 |
| | 1 000 | | 200 |
| | 1 250 | | 250 |
| 10 | 7 100 | 170 | 710 |
| | 8 000 | | 800 |
| 15 | 7 500 | 180 | 500 |
| | 12 000 | | 800 |

## Beispiel III

Ein Werkstück und eine Plattierlösung wie in Beispiel I beschrieben werden verwendet. Die Lösung wird 20 Minuten lang in Kontakt mit der Oberfläche des Werkstückes gebracht, um eine reine Hintergrundplattierung zu bewirken, ohne dass die Ausfällung mit Hilfe der Strahlung gesteigert wird. Die Stärke der erhaltenen Plattierung ist geringer als 100 Å, was einer Ausfällungsrate von weniger als 0,1 Å/s entspricht.

## Beispiel IV

Die gleiche Art von Werkstücken, gleiche Plattierlösung und gleichartiger Aufbau des Lasers wie in Beispiel I beschrieben werden verwendet. Zum Vergleich werden zwei gleiche Werkstücke benutzt.

Die Nickelschicht auf dem ersten Werkstück wird mit der Plattierlösung in Kontakt gebracht und 10 Sekunden lang mit einem entsprechenden Brennfleck belichtet. Die erhaltene Plattierung ist 5 000 Å dick. Die Nickelschicht des zweiten Werkstückes wird mit der Plattierlösung in Kontakt gebracht und ebenfalls 10 Sekunden lang in gleichartiger Weise belichtet. Das zweite Werkstück wird jedoch anschliessend für weitere 60 Sekunden ohne Bestrahlung in der Plattierlösung belassen, bevor es heraus genommen wird. Jedoch auch hier ist die Stärke des Niederschlags ebenfalls 5 000 Å.

Durch Auswertung des Beispiels III kann man eine angenäherte Ausfällungsrate für die Hintergrundplattierung berechnen. Weil in 20 Minuten weniger als 100 Å abgelagert werden, beträgt die Ausfällungsrate für den Hintergrund etwa 0,1 Å/s. Wenn man diese Ausfällungsrate für die Plattierung des Hintergrundes mit der mittleren Ausfällungsrate für die Proben der Beispiele I und II vergleicht, kann man erkennen, dass die Ausfällungsrate erheblich gesteigert ist, wenn die Plattierung mit Hilfe der Laserstrahlung gefördert wird. Die Experimente wurden bei Raumtemperatur von etwa 25 °C ausgeführt. Dank der Förderung der Plattierung durch die Laserstrahlung ist jetzt die Ausfällungsrate etwa $10^3$ bis $10^4$ mal grösser als bei der Hintergrundplattierung.

Durch Vergleich der Beispiele I und II kann man feststellen, dass die Plattierung gefördert wird, unabhängig davon, ob die Strahlung von der Vorderseite oder von der Rückseite her einfällt. Im zweiten Falle wird der Strahl durch die ausgefällte Plattierung unterbrochen, so dass der Strahl weder die zu plattierende Oberfläche selbst noch die Plattierlösung belichtet. Der dem neuen Verfahren zugrunde liegende Mechanismus kann daher nicht durch eine Wechselwirkung der Strahlung mit der Plattierlösung begründet sein. Weiter kann der Mechanismus auch nicht durch eine Sensibilisierung der Oberfläche erklärt werden, was einer Art von Katalysatorwirkung gleichkäme.

Schliesslich zeigt das Beispiel IV, dass das Verfahren auch nicht durch eine Art Kernbildung gesteuert sein kann. Die verstärkte Plattierung oder Ausfällung beginnt, sobald die Strahlungsquelle wirksam ist, und sie hört sofort auf, sobald keine Strahlung mehr einwirkt. Der dem neuen Verfahren zugrunde liegende Mechanismus kann daher keine Kernbildung sein.

Das beschriebene Verfahren zum elektrodenlosen Plattieren ist für solche Anwendungen gut geeignet wie die Reparatur von integrierten Schaltungen, die Herstellung von Leitungszügen für Gasentladungstafeln (für die Anzeige und Darstellung von Daten) oder die Herstellung von Uebertragungsleitungen auf Substraten.

Das Verfahren ermöglicht auch eine bevorzugte Plattierung in ausgewählten Gebieten, wo lokal die Stärke von Schichten vergrössert werden kann. Durch diese verstärkten Metallschichten können auch mechanische Eigenschaften wie die Abriebfestigkeit verbessert werden.

### Ansprüche

1. Verfahren zum selektiven Plattieren der Oberfläche eines Werkstücks, dadurch gekennzeichnet, dass man das Werkstück mit einer Plattierlösung in Kontakt bringt, und dass man während des Plattierens die zu plattierenden Bereiche selektiv einer scharf gebündelten elektromagnetischen Strahlung aussetzt, welche die ausgewählten Bereiche lokal aufheizt und dort die Ausfällungsrate steigert.

2. Verfahren nach Anspruch 1, dadurch gekennzeichnet, dass man die genannte Strahlung mittels eines Lasers erzeugt und dass man mit einer Energiedichte zwischen $10^2$ W/cm$^2$ und $10^6$ W/cm$^2$ im Brennfleck arbeitet.

3. Verfahren nach Anspruch 2, dadurch gekennzeichnet, dass man den Laserstrahl moduliert.

4. Verfahren nach Anspruch 1, dadurch gekennzeichnet, dass man ein Werkstück zusammengesetzter Struktur verwendet, welches aus einem schlecht wärmeleitenden Substrat besteht, das eine Schicht an der Oberfläche trägt, welche die Strahlungsenergie stark absorbiert.

5. Verfahren nach Anspruch 4, dadurch gekennzeichnet, dass man ein für die Strahlung transparentes Substrat verwendet, und dass man die Strahlung von der Rückseite her auf das Werkstück richtet, so dass sie die Grenzschicht der Oberflächenschicht lokal aufheizt.

6. Verfahren nach Anspruch 4, dadurch gekennzeichnet, dass die Stärke der Oberflächenschicht nicht grösser ist als die kleinsten Abmessungen von zu plattierenden Mustern.

### Claims

1. Selective plating process for the surfaces of a workpiece, characterized in that the workpiece is contacted with a plating solution and that, during plating, the regions to be plated are selectively subjected to a focused electromagnetic beam which results, at the selected regions, in local heating and an increased plating rate.

2. Process as claimed in claim 1, characterized in that the beam is generated by a laser operated with an intensity of between $10^2$ W/cm$^2$ and $10^6$ W/cm$^2$ at the focal spot.

3. Process as claimed in claim 2, characterized in that the laser beam is modulated.

4. Process as claimed in claim 1, characterized in that a workpiece of composite structure is used which comprises a thermally insulating substrate supporting a film at its surface which strongly absorbs the beam's energy.

5. Process as claimed in claim 4, characterized in that the substrate used is transparent to the beam and that the beam is directed at the back of the workpiece such that the interface between substrate and film is locally heated.

6. Process as claimed in claim 4, characterized in that the film has a thickness no greater than the minimal dimension of the pattern to be plated.

### Revendications

1. Procédé pour le placage sélectif de la surface d'une pièce de travail, caractérisé en ce que la pièce de travail est mise en contact avec une solution de placage et en ce que, durant le placage, les régions à plaquer sont sélectivement exposées à un rayonnement électromagnétique focalisé qui chauffe localement les régions sélectionnées et y augmente la vitesse de précipitation.

2. Procédé selon la revendication 1, caractérisé en ce que ledit rayonnement est généré à l'aide d'un laser et en ce que l'on utilise une densité d'énergie au foyer comprise entre $10^2$ W/cm$^2$ et $10^6$ W/cm$^2$.

3. Procédé selon la revendication 2, caractérisé en ce que le faisceau laser est modulé.

4. Procédé selon la revendication 1, caractérisé en ce que l'on utilise une pièce de travail de structure composite qui comporte un substrat à conduction thermique faible dont la surface est recouverte d'une couche qui absorbe fortement l'énergie de rayonnement.

5. Procédé selon la revendication 4, caractérisé en ce qu'on utilise un substrat transparent pour le rayonnement et en ce que le rayonnement est dirigé sur la pièce de travail par son verso de sorte qu'il chauffe localement la couche limite de la couche de surface.

6. Procédé selon la revendication 4, caractérisé en ce que l'épaisseur de la couche de surface ne dépasse pas les dimensions les plus petites des configurations à plaquer.

# FIG. 1

# FIG. 2